# FASCICULE DE BREVET EUROPEEN

(11) **EP 2 259 302 B1**
(45) Date de publication et mention de la délivrance du brevet: **03.07.2013**
(21) Numéro de dépôt: 10179437.8
(22) Date de dépôt: 29.07.2004
(51) Int. Cl.: H01L 21/762

(54) **Procédé d'obtention d'une couche mince de qualité accrue par co-implantation et recuit thermique.**
Herstellungsverfahren einer dünnen Schicht mit höherer qualität durch koimplantation und thermischer Behandlung.
Method for obtaining a thin layer with enhanced quality by co-implanting and thermal annealing

(30) Priorité: 29.07.2003 FR 0309304; 21.10.2003 US 691403
(43) Date de publication de la demande: 08.12.2010
(62) Demande divisionnaire de: 04786008.5
(73) Titulaire: Soitec, 38190 Bernin (FR)
(72) Inventeur: Maleville, Christophe, 38660, La Terrasse (FR); Neyret, Eric, 30330, Gaujac (FR); Ben Mohammed, Nadia, 38140, Renage (FR)
(74) Mandataire: Regimbeau

(56) Documents cités:
- EP-A- 0 954 014
- EP-A1- 1 045 448
- FR-A- 2 797 713
- US-A1- 2002 025 604
- US-B1- 6 593 212
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 mars 1998 (1998-03-02), pages 1086-1088, XP000742819 ISSN: 0003-6951

## Description

La présente invention concerne un procédé de réalisation d'une structure comprenant une couche mince de matériau semi-conducteur sur un substrat, comportant les étapes consistant à :
o réaliser une co-implantation des espèces Hydrogène et Hélium sous une face d'un substrat donneur à partir duquel la couche mince doit être réalisée, de manière à créer une zone de fragilisation dans l'épaisseur du substrat donneur ;
o mettre en contact intime la face du substrat donneur ayant subi l'implantation avec un substrat support ;
o détacher le substrat donneur au niveau de la zone de fragilisation, pour transférer une partie du substrat donneur sur le substrat support et former la couche mince sur celui-ci ;
le procédé étant caractérisé:
o en ce qu'il comporte après détachement une étape de minimisation de la rugosité hautes fréquences de la surface de la couche mince formée sur le substrat support réalisée au moyen d'au moins une opération de recuit thermique rapide de la structure obtenue après détachement sous une atmosphère d'argon pur, d'hydrogène pur ou sous un mélange d'hydrogène et d'argon ;
o et en ce que lors de l'étape d'implantation, l'Hélium est implanté avant l'Hydrogène.

Par implantation d'espèces, on entend tout bombardement d'espèces atomiques ou ioniques, susceptible d'introduire ces espèces dans le matériau du substrat implanté, avec un maximum de concentration des espèces implantées situées à une profondeur déterminée du substrat par rapport à la surface bombardée.

On connaît déjà des procédés du type mentionné ci-dessus.

Les procédés de type SMARTCUT^{®} sont un exemple de procédé de ce type. Ces procédés correspondent à un mode préféré de mise en oeuvre de l'invention.

On trouvera de plus amples détails concernant le procédé SMARTCUT^{®} dans le document « Silicon-On-Insulator Technology : Materials to VLSI, 2nd Edition » de Jean-Pierre Colinge chez « Kluwer Academic Publishers », p.50 et 51, et dans le document US 2002/025604.

De tels procédés permettent de réaliser de manière avantageuse des structures comprenant une couche mince de matériau semi-conducteur.

Ces structures peuvent par exemple être de type SOI (Silicon On Insulator, pour Silicium sur Isolant, selon la terminologie anglo-saxonne répandue).

Les structures obtenues par de tels procédés sont mises en oeuvre pour des applications dans les domaines de la microélectronique, de l'optique et/ou de l'optronique.

Or, les spécifications d'état de surface des structures utilisées dans ces domaines sont généralement très sévères.

La rugosité de la couche mince est en effet un paramètre qui conditionne dans une certaine mesure la qualité des composants qui seront réalisés sur la structure.

La rugosité est généralement exprimée soit par une valeur quadratique moyenne dite RMS (selon l'acronyme de l'expression anglo-saxonne « Root Mean Square »), soit par une densité spectrale de puissance dite PSD (selon l'acronyme de l'expression anglo-saxonne « Power Spectral Density »).

A titre d'exemple, il est courant de trouver des spécifications de rugosité ne devant pas dépasser 5 Angströms en valeur RMS.

Les mesures de rugosité peuvent en particulier être effectuées grâce à un microscope à force atomique AFM (selon l'acronyme de l'appellation anglo-saxonne Atomic Force Microscop).

Avec ce type d'appareil, la rugosité est mesurée sur des surfaces balayées par la pointe du microscope AFM, allant de 1x1 µm² à 10x10 µm², et plus rarement 50 x50 µm², voir 100x100 µm².

La rugosité peut être caractérisée, en particulier, selon deux modalités.

Selon l'une de ces modalités, la rugosité est dite à hautes fréquences et correspond à des surfaces balayées de faibles dimensions (de l'ordre de 1x1 µm²).

Selon l'autre des ces modalités, la rugosité est dite à basses fréquences et correspond à des surfaces balayées de dimensions plus importantes (de l'ordre de 10x10 µm², ou plus).

Les « hautes fréquences » et « basses fréquences » mentionnées ci-dessus correspondent ainsi à des fréquences spatiales liées à la mesure de rugosité.

La spécification de 5 Angströms RMS donnée ci-dessus à titre indicatif est ainsi une rugosité à basses fréquences, correspondant à une surface balayée de 10x10 µm².

Une faible rugosité à hautes fréquences est en particulier désirée pour obtenir de bons oxydes de grille.

Une faible rugosité à basses fréquences (ou encore « ondulation ») est intéressante notamment lorsque l'on souhaite coller un autre substrat sur la surface libre de la couche mince.

Les couches minces qui sont obtenues par les procédés de transfert connus (par exemple de type SMARTCUT^{®}) présentent des rugosités de surface dont les valeurs sont généralement supérieures à des spécifications telles que mentionnées ci-dessus, en l'absence de l'application à la surface de la couche mince d'un traitement spécifique.

Des étapes de finition sont ainsi généralement mises en oeuvre sur la structure suite à l'étape de détachement, de manière à améliorer la qualité de la couche mince transférée.

Plus précisément, ces étapes de finition ont notamment pour objectif de gommer toutes les rugosités, c'est-à-dire aussi bien les rugosités à hautes fréquences que les rugosités à basses fréquences.

Ces étapes de finition font généralement intervenir des opérations telles qu'un polissage mécano-chimique (ou CMP selon l'acronyme de l'expression anglo-saxonne Chemical-Mechanical Polishing), un recuit en four, un recuit rapide, une séquence d'oxydation/désoxydation.

Un premier type de procédé connu pour diminuer la rugosité de surface consiste ainsi à effectuer un polissage mécano-chimique de la surface libre de la couche mince.

Ce type de procédé permet effectivement de réduire la rugosité de la surface libre de la couche mince en diminuant toutes les ondulations, et notamment celles à plus basses fréquences.

Cependant, le polissage mécano-chimique induit des défauts (par exemple par écrouissage) dans la couche mince.

En outre, il compromet l'uniformité de la surface libre de la couche mince (en particulier l'uniformité selon les très basses fréquences).

Ces inconvénients sont de plus accrus dans le cas où l'on procède à un polissage important de la surface de la couche mince.

En alternative à un tel polissage CMP, il a été proposé de traiter la surface de la structure par un recuit sous atmosphère hydrogénée.

Le document EP 954 014 propose ainsi un procédé de finition permettant de diminuer la rugosité d'une couche mince transférée suivant un procédé de type SMARTCUT ®, ledit procédé de finition comprenant, suite à l'étape de détachement, un recuit thermique sous atmosphère réductrice contenant de l'hydrogène.

Le recuit thermique sous atmosphère réductrice contenant de l'hydrogène permet de gommer les rugosités hautes fréquences par une reconstruction de la surface.

Mais ce traitement ne permet pas d'éliminer totalement les rugosités de plus basses fréquences (5 à 10 micromètres).

Il a par ailleurs été proposé dans le document FR 2 797 713 de combiner deux types de traitement de surface différents, chacun de ces deux types de traitement agissant sur des plages distinctes de fréquence de rugosité.

Il est pour cela procédé à une étape de recuit thermique rapide sous atmosphère réductrice ainsi qu'à une étape de polissage mécano-chimique (CMP), ces étapes se distinguant par leurs effets sur des plages de fréquence différentes.

Dans le cas d'un tel traitement, le recuit sous atmosphère réductrice favorise un lissage de la rugosité à hautes fréquences (période spatiale inférieure à 3 Angströms), mais est moins efficace pour réduire les ondulations, qui sont plutôt de basses fréquences.

Le polissage mécano-chimique est quant à lui efficace pour diminuer les ondulations à basses fréquences.

Mais comme on l'a vu précédemment, le polissage mécano-chimique est intrinsèquement associé à certains inconvénients.

Il apparaît ainsi que les procédés connus pour améliorer la qualité de la couche mince d'une structure du type mentionné ci-dessus sont associés à des limitations ou à des inconvénients.

Un but de l'invention est de permettre de s'affranchir de ces limitations et inconvénients.

Plus spécifiquement, un autre but de l'invention est de permettre un traitement efficace des rugosités tant basses fréquences que hautes fréquences des structures, sans recourir à un polissage de type CMP.

Un but de l'invention est ainsi d'améliorer la qualité de la couche mince superficielle, étant précisé que par amélioration de la qualité on entend aussi bien :
- la diminution de la rugosité de surface et l'amélioration de l'uniformité de la couche mince, que
- la réduction de la densité de défauts présents dans la couche mince.

Afin d'atteindre ces buts, l'invention propose, un procédé de réalisation d'une structure comprenant une couche mince de matériau semi-conducteur sur un substrat conformément à la revendication 1.

Des aspects préférés, mais non limitatifs du procédé selon le premier aspect de l'invention sont les suivants :
- la dose d'Hélium implantée est sensiblement comprise entre 0,7.10¹⁶.cm⁻² et 1,2.10¹⁶.cm⁻² et en ce que la dose d'Hydrogène implantée est sensiblement comprise entre 0,7.10¹⁶.cm⁻² et 2.10¹⁶.cm⁻² ;
- le recuit thermique rapide (RTA) est réalisé à une température comprise entre 900°C et 1300°C pendant 1 à 60 secondes ;
- le recuit RTA est réalisé sous une atmosphère comprenant un mélange d'hydrogène de d'argon, ou une atmosphère d'argon pur, ou une atmosphère d'hydrogène pur ;
- ladite étape de finition peut comporter en outre au moins une opération d'oxydation stabilisée StabOx de la structure obtenue après détachement ;
- ladite opération de StabOx met successivement en oeuvre une opération d'oxydation, une opération de recuit et une opération de désoxydation ;
- ladite opération de recuit est réalisé pendant deux heures à une température d'environ 1100°C ;
- au cours de l'étape de finition, l'opération de recuit RTA peut être réalisée préalablement à l'opération de StabOx ;
- ladite étape de finition peut comporter une pluralité de séquences RTA / StabOx ;
- au cours de l'étape de finition, l'opération de StabOx peut également être réalisée préalablement à l'opération de recuit RTA ;
- ladite étape de finition peut comporter une pluralité de séquences StabOx / RTA ;
- la ou les opérations de StabOx peuvent être remplacées par une opération d'oxydation simple, ladite opération d'oxydation simple comprenant une opération d'oxydation de la structure obtenue après détachement suivie d'une opération de désoxydation ;

D'autres caractéristiques, buts et avantages de l'invention apparaîtront à la lecture de la description détaillée qui va suivre, et au regard des dessins annexés, donnés à titre d'exemples non limitatifs et sur lesquels :
- la figure 1 représente des mesures de rugosité de type PSD réalisées au centre de différentes structures, et illustre la réduction de rugosité à basses fréquences qui peut être réalisée en mettant en oeuvre le procédé selon l'invention, par rapport à ce qu'on obtient par un simple traitement thermique de type RTA ;
- la figure 2 représente des mesures de rugosité RMS et illustre la réduction de rugosité basses fréquences réalisée grâce au procédé selon l'invention, et ce sans recourir à une étape de CMP ;
- les figures 3a et 3b sont des représentations analogues à celle de la figure 1, qui illustrent la réduction de rugosité obtenue grâce à l'invention, respectivement au centre d'une structure et au bord de cette structure.

Comme cela a déjà été exposé précédemment, l'invention concerne la réalisation de structures comprenant une couche mince de matériau semi-conducteur sur un substrat support, la couche mince étant obtenue par détachement au niveau d'un substrat donneur préalablement fragilisé par implantation d'espèces.

La structure peut, de manière générale, être tout type de structure comportant sur une surface exposée à l'environnement extérieur (surface libre) une couche mince d'un matériau semiconducteur.

De manière non limitative, la couche mince de matériau semi-conducteur peut être en silicium Si, en carbure de silicium SiC, en germanium Ge, en silicium-germanium SiGe, en arséniure de gallium AsGa, etc.

Le substrat support peut être en silicium Si, en Quartz, etc.

Une couche d'oxyde peut également être intercalée entre le substrat support et la couche mince, la structure ainsi formée étant une structure semiconducteur-sur-isolant (structure SeOl selon l'acronyme de l'expression anglo-saxonne « Semi-Conductor On Insulator », et en particulier par exemple structure SOI).

L'invention peut en particulier permettre d'améliorer la qualité de la couche mince d'une structure obtenue par mise en oeuvre d'un procédé de transfert de type SMARTCUT^{®}.

Dans le cadre d'un tel procédé de transfert, l'invention pourra être mise en oeuvre avec profit pour diminuer la rugosité de l'une ou l'autre des deux surfaces de matériau semiconducteur qui sont issues du détachement au niveau de la zone de fragilisation, ou de ces deux surfaces.

Dans le cadre du procédé selon l'invention :
- l'étape d'implantation d'espèces visant à créer une zone de fragilisation est réalisée par co-implantation d'au moins deux espèces différentes sous une face du substrat donneur,
- on procède en outre, après le détachement au niveau de la zone de fragilisation, à une étape de finition par recuit thermique rapide.

Selon l'invention, ce sont les espèces Hydrogène et Hélium qui sont ainsi co-implantées sous la face du substrat donneur pour former la zone de fragilisation.

La co-implantation est réalisée en implantant séquentiellement l'Helium puis l'Hydrogène.

En menant des expérimentations sur la co-implantation, la Demanderesse a observé que la co-implantation d'Hélium et d'Hydrogène conduisait à transférer des couches minces avec un niveau de rugosité réduit par rapport au transfert faisant suite à une implantation d'Hydrogène seul.

Plus précisément, la Demanderesse a observé que les fréquences auxquelles cette amélioration de la rugosité apparaît le plus notablement correspondent aux fréquences de rugosité de plus basses fréquences spatiales, c'est à dire les fréquences généralement bien traitées par la CMP.

Dans le cadre du procédé selon l'invention, la face du substrat donneur ayant subi la co-implantation est ensuite mise en contact intime avec le substrat support.

Le substrat donneur est alors détaché au niveau de la zone de fragilisation, pour transférer une partie du substrat donneur sur le substrat support et former la couche mince sur celui-ci.

Ces étapes de mise en contact intime et de détachement sont connues de l'homme du métier et classiquement mises en oeuvre dans les procédés de transfert mentionnés précédemment.

Le détachement peut ainsi être réalisé par apport d'énergie thermique, éventuellement complété par une action mécanique au niveau de la zone de fragilisation.

Le procédé selon l'invention comporte par ailleurs une étape de finition visant notamment à minimiser les rugosités hautes fréquences au niveau de la structure obtenue après détachement.

Une telle étape de finition comporte pour cela au moins une étape de recuit thermique rapide.

Par « recuit thermique rapide », on entend un recuit rapide (c'est à dire effectué pendant une durée de quelques secondes ou quelques dizaines de secondes), sous atmosphère contrôlée.

Un tel recuit est communément désigné par l'appellation de recuit RTA (correspondant à l'acronyme de l'expression anglo-saxonne Rapid Thermal Annealing).

Pour réaliser un recuit RTA de la structure, on recuit la structure à une température élevée, pouvant être par exemple de l'ordre de 900° C à 1300° C, pendant 1 à 60 secondes.

Le recuit RTA est effectué sous atmosphère contrôlée. Cette atmosphère peut être par exemple une atmosphère comprenant un mélange d'hydrogène et d'argon, ou une atmosphère d'argon pur, ou encore une atmosphère d'hydrogène pur.

L'étape de recuit RTA permet en particulier de réduire la rugosité de la surface de la couche mince, essentiellement par reconstruction de surface et lissage.

Et, comme cela a été mentionné précédemment, le recuit RTA favorise en particulier une réduction de la rugosité à hautes fréquences.

En outre, les défauts cristallins présents dans la couche mince, et générés en particulier au cours de l'implantation et du détachement, sont au moins en partie guéris par ce recuit RTA.

Le procédé selon l'invention pour l'obtention d'une structure avec une couche mince de bonne qualité ne met ainsi pas en oeuvre de CMP, mais permet toutefois de réduire aussi bien les rugosités hautes fréquences, que les rugosités basses fréquences.

La mise en oeuvre du procédé selon l'invention permet ainsi d'obtenir une structure comprenant une couche mince dont la qualité est suffisante et compatible avec l'utilisation de cette couche mince dans les applications en micro ou opto électronique.

Selon une variante de mise en oeuvre, ladite étape de finition peut également comprendre au moins une étape d'oxydation stabilisée (également dénommée StabOx par la suite).

Une étape de StabOx est classiquement mise en oeuvre dans un procédé de transfert, suite à l'étape de détachement, notamment pour :
- contrôler l'épaisseur de la couche mince et y réduire la densité de défauts ;
- renforcer l'interface entre la couche mince et le substrat support.

On précise que par la suite une étape de StabOx sera comprise comme la succession des opérations suivantes :
- un traitement thermique comportant successivement :
   ➢ une oxydation de la structure. √
      Une telle oxydation, classiquement connue de l'homme du métier, peut être par exemple menée en chauffant ladite structure aux environs de 900°C sous oxygène gazeux. √
      Suite à cette oxydation, une couche d'oxyde est alors formée sur la couche mince. √
   un recuit de la structure à 1100°C environ pendant deux heures, sous atmosphère d'Argon par exemple. Ce recuit permet à la fois de :
      √ renforcer l'interface entre le substrat support et la face du substrat donneur ayant subi l'implantation, et de
      √ guérir certains défauts générés au cours des étapes d'implantation et de détachement.
- une opération de désoxydation, qui est réalisée suite au traitement thermique, de manière à retirer la couche d'oxyde formée lors de l'opération d'oxydation.

Une telle désoxydation, connue en soi, peut être par exemple menée en plongeant la structure pendant quelques minutes, dans une solution d'acide fluorhydrique à 10% ou 20% par exemple.

On notera que la couche d'oxyde formée au cours d'oxydation permet de protéger, au cours du recuit qui suit la couche mince sous-jacente.

On notera également qu'une partie de la couche mince, à proximité de sa surface libre, est ainsi consommée lors d'une telle opération de StabOx.

En mettant en oeuvre, au cours de l'étape de finition, en sus de l'étape de RTA, une étape de StabOx, le procédé selon l'invention permet en particulier :
- de réduire encore davantage la concentration de défauts dans la couche mince, et
- d'amener la structure à l'épaisseur visée pour le produit fini.

En effet, comme cela a déjà été mentionné, le recuit RTA permet de reconstruire la surface de la couche mince, et de guérir certains défauts dans l'épaisseur de celle-ci.

Si cette guérison peut, dans certains cas, n'être que partielle, la réalisation d'une étape supplémentaire de StabOx permet un enlèvement de la matière comportant une grande partie des défauts situés au voisinage de la surface libre de la couche mince et dans l'épaisseur de celle-ci.

Ceci correspond donc encore à une amélioration de la qualité de la structure.

Cette variante du procédé selon l'invention, dans lequel l'étape de finition comporte une étape de RTA et au moins une étape de StabOx, est ainsi particulièrement avantageuse lorsqu'il existe pour les défauts un gradient de concentration croissant en direction de la surface libre de la couche mince, et une importante concentration de défauts au voisinage de cette surface.

On notera que l'épaisseur totale consommée par une ou plusieurs séquences StabOx / désoxydation peut être avantageusement contrôlée afin de supprimer tous les défauts et d'amener la structure à l'épaisseur désirée.

Selon un mode de réalisation particulièrement avantageux de l'invention, une étape de StabOx est réalisée, au cours de l'étape de finition, postérieurement à l'étape de RTA.

Cette séquence RTA / StabOx permet d'obtenir une meilleure uniformité d'oxydation que lorsque l'étape de StabOx est réalisée directement après détachement, sans mise en oeuvre préalable de l'étape de RTA lissant.

En effet, lorsqu'une étape de RTA est mise en oeuvre préalablement à une étape de StabOx, la rugosité de surface est plus faible et la surface de la couche mince est plus uniforme.

De telle sorte, la vitesse d'oxydation est proche de celle qui est obtenue lorsque l'on oxyde une structure polie, et est de plus, la même en tout point de la structure.

En outre, il peut être utile de guérir les défauts cristallins présents dans la couche mince (grâce au RTA) avant de consommer de son épaisseur (lors de la séquence StabOx/desoxydation)

Cela est d'autant plus intéressant lorsque la couche mince est particulièrement fine, et qu'une consommation de son épaisseur est susceptible par exemple de déboucher des trous non préalablement guéris et rebouchés par un recuit RTA.

Selon d'autres modes de mise en oeuvre de l'invention, l'étape de finition comprenant au moins une opération de RTA, peut consister en l'une des séquences suivantes :
- RTA / StabOx (comme cela vient juste d'être discuté);
- une répétition de plusieurs séquences RTA / StabOx (l'exemple de mise en oeuvre discuté ci-après comprenant, en succession, deux de ces séquences RTA / StabOx) ;
- StabOx / RTA ;
- StabOx / RTA / StabOx / RTA ;

Lorsque l'étape de finition comporte au moins un traitement RTA additionnel (comme cela peut être le cas lorsque des séquences RTA/StabOX ou StabOx/RTA sont répétées plusieurs fois), le traitement RTA additionnel permet de continuer à lisser la surface libre de la couche mince.

Ledit traitement RTA additionnel peut en outre être réalisé à plus basse température (par exemple 1000 à 1100°C) que le premier traitement RTA.

Il est ainsi possible de réduire le budget thermique de la répétition des séquences mentionnée ci-dessus, en réalisant un traitement RTA plus basse température.

Selon un mode de réalisation particulier de l'invention, une opération dite d'oxydation simple est réalisée à la place d'une étape de StabOx telle que mentionnée ci-dessus.

Cette opération d'oxydation simple comprend successivement une étape d'oxydation et une étape de désoxydation.

Le budget thermique peut alors être également réduit puisque la seconde opération de la StabOx (recuit thermique pendant deux heures environ) n'est pas mise en oeuvre.

La réduction du budget thermique est avantageuse, dans la mesure où elle permet de limiter les contraintes appliquées à la structure, réduisant la probabilité de génération de défauts de type dislocations ou lignes de glissement (« slip-lines » selon la terminologie anglo-saxonne) dans l'arrangement cristallographique de la structure.

L'étape d'oxydation suivie de l'étape de désoxydation peut ainsi remplacer l'étape de StabOx dans l'ensemble des enchaînements mentionnés ci-dessus.

On va maintenant décrire ci-dessous de manière détaillée un mode de mise en oeuvre du procédé conforme à l'invention, à titre d'exemple non limitatif.

Ce mode de mise en oeuvre est relatif à la réalisation de structures S1, S2, S3 comprenant une couche mince sur un substrat support.

L'épaisseur de la couche mince de ces structures respectives est comprise entre 50 et 2000 Angströms, l'épaisseur totale de ces structures étant d'environ 700 µm.

Ces structures S1, S2, S3 sont réalisées en mettant en oeuvre, au cours de l'étape d'implantation d'espèces, une co-implantation d'Hélium puis d'Hydrogène, avec des doses respectives de :
- Hélium, 0,7.10¹⁶.cm⁻² et Hydrogène, 0,9.10¹⁶.cm⁻² pour la structure S1 ;
- Hélium, 0,8.10¹⁶.cm⁻² et Hydrogène, 0,9.10¹⁶.cm⁻² pour la structure S2 ;
- Hélium, 0,9.10¹⁶.cm⁻² et Hydrogène, 0,9.10¹⁶.cm⁻² pour la structure S3 ;

A titre de comparaison, une structure S4 est réalisée via une implantation d'Hydrogène seul, avec une dose de 5,5.10¹⁶.cm⁻², soit une dose quasiment trois fois supérieure à la dose totale implantée lors de la co-implantation.

Un avantage classiquement observé de la technique de co-implantation est donc ici mis en évidence, avec par rapport à une implantation d'un seul type d'espèces une réduction d'un facteur 3 environ de la dose implantée.

Cette réduction se traduit par une réduction du temps d'implantation, et finalement des coûts associés à la production de structures comportant une couche mince sur un substrat support, en particulier à l'aide d'un procédé de transfert de type SMARTCUT^{®}.

Cet avantage connu est par exemple mis en évidence dans le document de Aditya Agarwal, T. E. Haynes, V. C. Venezia, O. W. Holland, and D. J. Eaglesham, "Efficient production of silicon-on-insulator films by co-implantation of He+ with H+ " Applied Physics Letters, vol. 72 (1998), pp. 1086-1088, dans lequel il est fait état que la co-implantation d'Hydrogène et d'Hélium permet de diminuer les doses devant être implantées.

On notera qu'il est par ailleurs constaté dans ce document que la couche superficielle d'un SOI obtenue par co-implantation d'Hydrogène et d'Hélium présente une rugosité comparable à celle de la couche de surface d'un SOI obtenu par implantation d'Hydrogène seul.

Le document qui vient d'être cité n'évoque ainsi aucunement une quelconque amélioration de rugosité de surface du fait d'une co-implantation (et a fortiori ne propose évidemment aucune exploitation d'un tel effet).

Revenant à la description de l'invention, suite à l'étape de co-implantation, on procède, comme cela a déjà été mentionné, aux étapes classiques de mise en contact intime et de détachement, puis à une étape de finition comportant au moins un RTA, de manière à obtenir les structures finales S1, S2, S3, S4.

Des mesures de rugosité PSD de chacune de ces structures ont été réalisées à l'aide d'un microscope AFM.

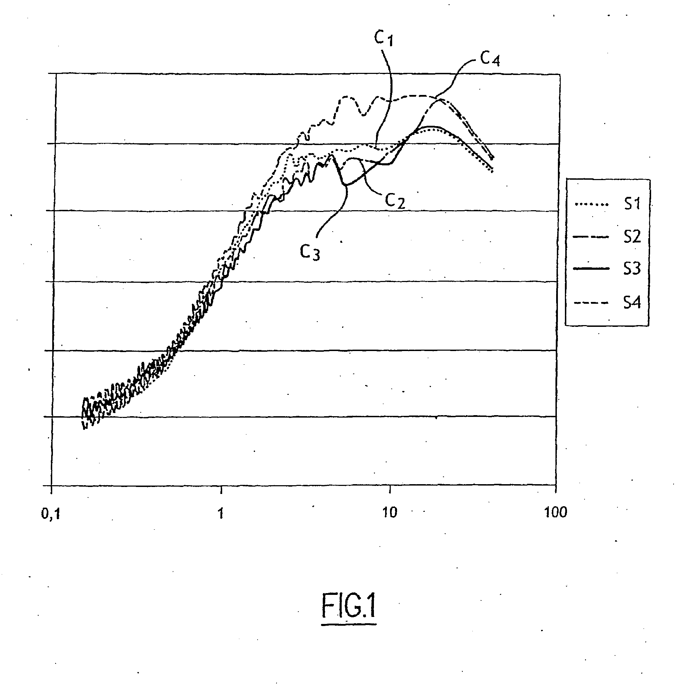

La figure 1 représente ainsi la puissance des différentes composantes spectrales de la rugosité de chacune des structures S1, S2, S3, S4.

L'axe des abscisses porté sur le graphique de la figure 1 est ainsi la période spatiale (en µm), qui décrit les fréquences de rugosité observées, des hautes fréquences (à gauche de cet axe) vers les basses fréquences (à droite de cet axe).

Ces mesures ont plus précisément été réalisées en bord de structure, c'est-à-dire au niveau de la zone où le détachement est amorcé lors de l'étape de détachement, cette zone présentant par conséquent généralement une rugosité relativement élevée.

La figure 1 représente le résultat de telles mesures sur une surface balayée de 40*40 µm² (cette surface de 40*40 µm² correspondant ainsi la fréquence maximale selon laquelle la rugosité est observée).

La figure 1 permet ainsi d'illustrer la différence de rugosité entre les structures S1, S2, S3, S4, à l'issue du traitement RTA de l'étape de finition desdites structures.

Une première courbe C4 illustre la rugosité de la structure S4 réalisée classiquement par implantation d'hydrogène seul.

Trois autres courbes C1, C2, C3 illustrent la rugosité des structures respectivement S1, S2 et S3 réalisées selon le procédé de l'invention, combinant co-implantation et recuit RTA.

Ces trois courbes C1, C2, C3 correspondent à des doses différentes des espèces co-implantées.

La figure 1 caractérise le faciès de fracture à travers l'analyse des fréquences composant la rugosité, et démontre l'avantage procuré par l'association, selon l'invention, de la co-implantation avec le RTA.

La figure 1 permet effectivement de constater que la rugosité basses fréquences des structures S1, S2 et S3 réalisées selon l'invention est sensiblement plus faible que celle de la structure S4 réalisée de manière classique.

On observe en particulier une nette diminution de la rugosité pour des périodes spatiales sensiblement comprises entre 3 et 15 µm.

La co-implantation permet ainsi de limiter la rugosité basses fréquences, alors que la rugosité hautes fréquences est équivalente, voir légèrement inférieure, au cas d'une implantation d'Hydrogène seul.

La succession selon l'invention des étapes de co-implantation / mise en contact / détachement / RTA permet ainsi d'atteindre des rugosités globalement plus faibles que dans la cas de la succession connue des étapes d'implantation d'Hydrogène seul / mise en contact / détachement / RTA.

Il est en outre possible de jouer sur les doses d'implantation des espèces co-implantées (en particulier la dose d'Helium dans l'exemple ici présenté) tout en conservant une rugosité basses fréquences plus faible que celle classiquement constatée.

Selon le mode de mise en oeuvre du procédé conforme à l'invention ici détaillé, l'étape de finition comporte, en sus de l'étape de RTA, des étapes successives de StabOx, RTA et StabOx (soit une étape de finition comportant une répétition de deux séquences RTA/StabOx).

Comme cela a déjà été présenté précédemment, une telle étape de finition permet de :
- consommer de l'épaisseur de la couche mince et réduire les défauts d'implantation résiduels sous la surface après détachement ;
- consolider l'interface de collage couche mince / substrat support via le recuit réalisé lors des étapes de StabOx ;
- amener la structure à l'épaisseur visé pour le produit fini ;
- continuer à lisser la surface à l'aide du traitement RTA additionnel.

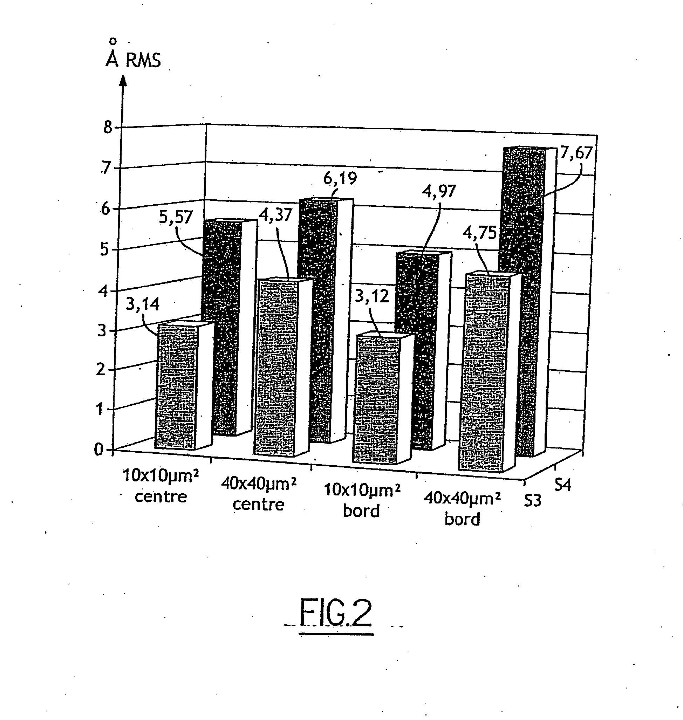

La figure 2 permet de comparer la rugosité RMS de la surface de la structure de type S3 obtenue par le mode de mise en oeuvre de l'invention à celle de la surface de la structure de type S4 obtenue par un procédé classique.

Des mesures de rugosité ont pour cela été réalisées à l'aide d'un microscope AFM balayant des surfaces de 10*10 µm² et de 40*40 µm² tant au centre des structures qu'en leur bord (i.e. zone où est amorcé le détachement).

Sur la figure 2 (axe des ordonnées en Angströms RMS), les barres au premier plan représentent les rugosités mesurées pour la structure de type S3, tandis que les barres au second plan représentent les rugosités mesurées pour la structure de type S4.

On observe sur cette figure 2, une nette diminution de la rugosité pour la structure S3, notamment pour les basses fréquences spatiales.

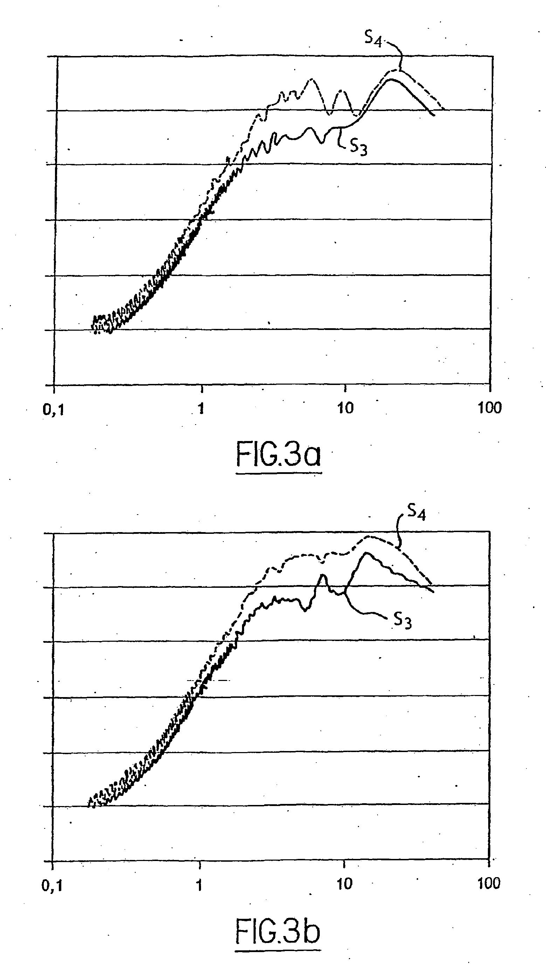

Les figures 3a et 3b sont des représentations analogues à celle de la figure 1, qui illustrent la réduction de rugosité obtenue grâce à l'invention, respectivement au centre d'une structure et au bord de cette structure.

Ces figures 3a et 3b permettent de comparer la rugosité PSD d'une structure de type S3 obtenue par le mode de mise en oeuvre de l'invention à celle d'une structure de type S4 obtenue par un procédé classique tant au centre desdites structures (figure 3a), qu'en leur bord (figure 3b).

Les surfaces balayées avaient une dimension de 40*40 µm².

On peut observer sur chacune de ces figures 3a et 3b, que la rugosité de la structure S3 est plus faible que celle de la structure S4, notamment à basses fréquences spatiales (en particulier lorsque la période spatiale est comprise entre 3 et 15 µm).

On notera en outre une uniformité de rugosité meilleure pour la structure S3 que pour la structure S4 (les différences d'uniformité entre le bord et le centre de la structure S3 étant effectivement atténuées).

On remarquera que le procédé selon l'invention constitue une approche originale qui permet de prévenir une rugosité importante (en particulier aux basses fréquences).

En ceci, l'invention se différencie des traitements connus qui sont « curatifs », dans la mesure où ils interviennent pour « rattraper » une rugosité donnée.

## Revendications

1. Procédé de réalisation d'une structure comprenant sur un substrat support une couche mince de matériau semi-conducteur dont la surface présente une rugosité basses fréquences comprise entre 4 et 5 Angströms RMS mesurée en balayant une surface de 40x40 µm² sans en réaliser un polissage mécano-chimique,
le procédé comportant les étapes consistant à :
• réaliser une co-implantation des espèces Hydrogène et Hélium sous une face d'un substrat donneur à partir duquel la couche mince doit être réalisée, de manière à créer une zone de fragilisation dans l'épaisseur du substrat donneur ;
• mettre en contact intime la face du substrat donneur ayant subi l'implantation avec un substrat support ;
• détacher le substrat donneur au niveau de la zone de fragilisation, pour transférer une partie du substrat donneur sur le substrat support et former la couche mince sur celui-ci ;
le procédé étant **caractérisé:**
• **en ce qu'**il comporte après détachement une étape de minimisation de la rugosité hautes fréquences de la surface de la couche mince formée sur le substrat support réalisée au moyen d'au moins une opération de recuit thermique rapide de la structure obtenue après détachement sous une atmosphère d'argon pur, d'hydrogène pur ou sous un mélange d'hydrogène et d'argon ;
• et **en ce que** lors de l'étape d'implantation, l'Hélium est implanté avant l'Hydrogène.

2. Procédé selon la revendication 1, **caractérisé en ce que** la dose d'Hélium implantée est sensiblement comprise entre 0,7.10¹⁶.cm⁻² et 1,2.10¹⁶.cm⁻² et **en ce que** la dose d'Hydrogène implantée est sensiblement comprise entre 0,7.10¹⁶.cm⁻² et 2.10¹⁶.cm⁻².

3. Procédé selon l'une des revendications précédentes, **caractérisé en ce que** le recuit thermique rapide (RTA) est réalisé à une température comprise entre 900°C et 1300°C pendant 1 à 60 secondes.

4. Procédé selon l'une des revendications précédentes, **caractérisé en ce que** ladite étape de finition comprend en outre au moins une opération d'oxydation stabilisée StabOx de la structure obtenue après détachement.

5. Procédé selon la revendication précédente, **caractérisé en ce que** ladite opération de StabOx met successivement en oeuvre une opération d'oxydation, une opération de recuit et une opération de désoxydation.

6. Procédé selon la revendication précédente, **caractérisé en ce que** ladite opération de recuit est réalisé pendant deux heures à une température d'environ 1100°C.

7. Procédé selon l'une des revendications 4 à 6, **caractérisé en ce que**, au cours de l'étape de finition, l'opération de recuit RTA est réalisée préalablement à l'opération de StabOx.

8. Procédé selon la revendication précédente, **caractérisé en ce que** ladite étape de finition comporte une pluralité de séquences RTA / StabOx.

9. Procédé selon l'une des revendications 4 à 6, **caractérisé en ce que** au cours de l'étape de finition, l'opération de StabOx est réalisée préalablement à l'opération de recuit RTA.

10. Procédé selon la revendication précédente, **caractérisé en ce que** ladite étape de finition comporte une pluralité de séquences StabOx / RTA.

11. Procédé selon l'une des revendications 1 à 3, **caractérisé en ce que** ladite étape de finition comprend en outre au moins une opération d'oxydation simple, ladite opération d'oxydation simple comprenant une opération d'oxydation de la structure obtenue après détachement suivie d'une opération de désoxydation.

12. Procédé selon la revendication précédente, **caractérisé en ce que**, au cours de l'étape de finition, l'opération de RTA est réalisée préalablement à ladite oxydation simple.

13. Procédé selon la revendication précédente, **caractérisé en ce que** ladite étape de finition comporte une pluralité de séquences RTA / oxydation simple.

14. Procédé selon la revendication 11, **caractérisé en ce que**, au cours de l'étape de finition, ladite oxydation simple est réalisée préalablement à l'opération de recuit RTA.

15. Procédé selon la revendication précédente, **caractérisé en ce que** ladite étape de finition comporte une pluralité de séquences oxydation simple / RTA.

## Patentansprüche

1. Verfahren zur Herstellung einer Struktur, die auf einem Trägersubstrat eine dünne Schicht aus einem Halbleitermaterial aufweist, deren Oberfläche eine niederfrequente Rauigkeit zwischen 4 und 5 Ångström RMS, gemessen durch Abtasten einer Oberfläche von 40x40µm², aufweist, ohne an dieser ein mechanischchemisches Polieren durchzuführen,
wobei das Verfahren die folgenden Schritte aufweist:
- Durchführen einer Coimplantation von Wasserstoff- und Helium-Teilchen unter eine Fläche eines Donatorsubstrats, aus welchem die dünne Schicht gewonnen werden soll, um eine Schwächezone in dem dicken Donatorsubstrat zu bilden;
- Bringen der Fläche des Donatorsubstrats, die der Implantation ausgesetzt war, in engen Kontakt mit einem Trägersubstrat;
- Trennen des Donatorsubstrats im Bereich der Schwächezone, um einen Teil des Donatorsubstrats auf das Trägersubstrat zu übertragen und auf diesem die dünne Schicht zu bilden;
wobei das Verfahren **dadurch gekennzeichnet ist,**
- **dass** es nach dem Trennen einen Schritt der Minimierung der hochfrequenten Rauheit der Oberfläche der auf dem Trägersubstrat gebildeten dünnen Schicht aufweist, der mit Hilfe einer schnellen thermischen Behandlung der nach dem Trennen gewonnenen Schicht unter einer Atmosphäre aus reinem Argon, reinem Wasserstoff oder unter einem Gemisch aus Wasserstoff und Argon durchgeführt wird; und
- **dass** bei dem Implantationsschritt das Helium vor dem Wasserstoff implantiert wird.

2. Verfahren nach Anspruch 1, **dadurch gekennzeichnet, dass** die implantierte Dosis Helium etwa zwischen 0,7*10¹⁶cm⁻² und 1,2*10¹⁶cm⁻² beträgt, und dadurch, dass die implantierte Dosis Wasserstoff etwa zwischen 0,7*10¹⁶cm⁻² und 2*10¹⁶cm⁻² beträgt.

3. Verfahren nach einem der vorstehenden Ansprüche, **dadurch gekennzeichnet, dass** die schnelle thermische Behandlung (RTA) bei einer Temperatur zwischen 900°C und 1300°C während 1 bis 60 Sekunden durchgeführt wird.

4. Verfahren nach einem der vorstehenden Ansprüche, **dadurch gekennzeichnet, dass** der Endbearbeitungsschritt außerdem mindestens einen Prozess einer stabilisierten Oxidation StabOx der nach dem Trennen gewonnenen Struktur aufweist.

5. Verfahren nach dem vorstehenden Anspruch, **dadurch gekennzeichnet, dass** der StabOx-Prozess der Reihe nach einen Oxidationsprozess, eine thermische Behandlung und einen Desoxidationsprozess aufweist.

6. Verfahren nach dem vorstehenden Anspruch, **dadurch gekennzeichnet, dass** die thermische Behandlung während zwei Stunden bei einer Temperatur von ungefähr 1100°C durchgeführt wird.

7. Verfahren nach einem der Ansprüche 4 bis 6, **dadurch gekennzeichnet, dass** im Verlaufe des Endbearbeitungsschritts die thermische Behandlung RTA vor dem StabOx-Prozess durchgeführt wird.

8. Verfahren nach dem vorstehenden Anspruch, **dadurch gekennzeichnet, dass** der Endbearbeitungsschritt mehrere Sequenzen von RTA/StabOx aufweist.

9. Verfahren nach einem der Ansprüche 4 bis 6, **dadurch gekennzeichnet, dass** im Verlaufe des Endbearbeitungsschritts der StabOx-Prozess vor der thermischen Behandlung RTA durchgeführt wird.

10. Verfahren nach dem vorstehenden Anspruch, **dadurch gekennzeichnet, dass** der Endbearbeitungsschritt mehrere Sequenzen von StabOx/RTA aufweist.

11. Verfahren nach einem der Ansprüche 1 bis 3, **dadurch gekennzeichnet, dass** der Endbearbeitungsschritt außerdem mindestens einen einfachen Oxidationsprozess aufweist, wobei der einfache Oxidationsprozess einen Prozess der Oxidation der nach dem Trennen gewonnenen Struktur gefolgt von einem Desoxidationsprozess aufweist.

12. Verfahren nach dem vorstehenden Anspruch, **dadurch gekennzeichnet, dass** im Verlaufe des Endbearbeitungsschritts die

13. Verfahren nach dem vorstehenden Anspruch, **dadurch gekennzeichnet, dass** der Endbearbeitungsschritt mehrere Sequenzen von RTA/einfacher Oxidation aufweist.

14. Verfahren nach Anspruch 11, **dadurch gekennzeichnet, dass** im Verlaufe des Endbearbeitungsschritts die einfache Oxidation vor der thermischen Behandlung RTA durchgeführt wird.

15. Verfahren nach dem vorstehenden Anspruch, **dadurch gekennzeichnet, dass** der Endbearbeitungsschritt mehrere Sequenzen von einfacher Oxidation/RTA aufweist.

## Claims

1. A process for producing a structure comprising, on a support substrate, a thin layer of semiconductor material whose surface has a low-frequencies roughness between 4 and 5 Angströms RMS measured by sweeping a surface of 40 x 40 µm² without carrying out chemical-mechanical polishing, comprising the following stages:
• carrying out co-implantation of hydrogen and helium species under a face of a donor substrate from which the thin layer must be made, so as to create an embrittlement zone in the thickness of the donor substrate,
• placing the face of the donor substrate which has undergone implantation, in close contact with a support substrate,
• detaching the donor substrate at the embrittlement zone, to transfer a part of the donor substrate onto the support substrate and form the thin layer on the latter,
**characterised in that**:
• it comprises, after detachment, a stage of minimization of the high-frequencies roughness of the surface of the thin layer formed on the support substrate, this stage comprising at least one rapid thermal annealing operation carried out in an atmosphere of pure argon, of pure hydrogen or comprising a mixture of argon and hydrogen of the structure obtained after detachment,
• and during the implantation stage, the helium is implanted before the hydrogen.

2. The process as claimed in Claim 1, **characterised in that** the dose of implanted helium is substantially between 0.7.10¹⁶.cm⁻² and 1.2.10¹⁶.cm⁻², and **in that** the dose of implanted hydrogen is substantially between 0.7.10¹⁶.cm⁻² and 2.10¹⁶.cm⁻².

3. The process as claimed in any one of the preceding claims, **characterised in that** the rapid thermal annealing (RTA) is carried out at a temperature of between 900°C and 1300°C for 1 to 60 seconds.

4. The process as claimed in any one of the preceding claims, **characterised in that** said finishing stage further comprises at least one operation of stabilised oxidation StabOx of the structure obtained after detachment.

5. The process as claimed in the preceding claim, **characterised in that** said StabOx operation successively implements an oxidation operation, an annealing operation and a deoxidation operation.

6. The process as claimed in the preceding claim, **characterised in that** said annealing operation is carried out during two hours at a temperature of around 1100°C.

7. The process as claimed in any one of Claims 4 to 6, **characterised in that**, during the finishing stage, the RTA annealing operation is carried out prior to the StabOx operation.

8. The process as claimed in the preceding claim, **characterised in that** said finishing stage comprises a plurality of RTA/StabOx sequences.

9. The process as claimed in any one of Claims 4 to 6, **characterised in that** during the finishing stage, the StabOx operation is carried out prior to the RTA annealing operation.

10. The process as claimed in the preceding claim, **characterised in that** said finishing stage comprises a plurality of StabOx/RTA sequences.

11. The process as claimed in any one of Claims 1 to 3, **characterised in that** said finishing stage also comprises at least one simple oxidation operation, said simple oxidation operation comprising an oxidation operation of the structure obtained after detachment followed by a deoxidation operation.

12. The process as claimed in the preceding claim, **characterised in that** during the finishing stage, the RTA operation is carried out prior to said simple oxidation.

13. The process as claimed in the preceding claim, **characterised in that** said finishing stage comprises a plurality of RTA/simple oxidation sequences.

14. The process as claimed in Claim 11, **characterised in that**, during the finishing stage, said simple oxidation is carried out prior to the RTA annealing operation.

15. The process as claimed in the preceding claim, **characterised in that** said finishing stage comprises a plurality of simple oxidation/RTA sequences.
